(19) Europäisches Patentamt
European Patent Office
Office européen des brevets

(11) **EP 1 282 174 B1**

(12) **EUROPÄISCHE PATENTSCHRIFT**

(45) Veröffentlichungstag und Bekanntmachung des Hinweises auf die Patenterteilung:
**18.06.2008 Patentblatt 2008/25**

(51) Int Cl.:
***H01L 41/053*** *(2006.01)*   *H04R 17/02* *(2006.01)*

(21) Anmeldenummer: **02090256.5**

(22) Anmeldetag: **16.07.2002**

(54) **Schwingungswandler mit piezoelektrischem Element**

Vibration transducer with piezoelectric element

Transducteur de vibrations avec élément piézoélectrique

(84) Benannte Vertragsstaaten:
**AT BE BG CH CY CZ DE DK EE ES FI FR GB GR IE IT LI LU MC NL PT SE SK TR**

(30) Priorität: **27.07.2001 DE 10137424**
**27.07.2001 DE 10137425**

(43) Veröffentlichungstag der Anmeldung:
**05.02.2003 Patentblatt 2003/06**

(73) Patentinhaber: **Holmberg GmbH & Co. KG**
**10999 Berlin (DE)**

(72) Erfinder:
• **Birth, Michael**
**10969 Berlin (DE)**
• **Badaljan, Petros**
**01217 Dresden (DE)**
• **Poljakova, Svetlana**
**344092 Rostov am Don (RU)**

• **Brajceva, Elena**
**344090 Rostov am Don (RU)**
• **Lupeiko, Timofej**
**344090 Rostov am Don (RU)**

(74) Vertreter: **Pfenning, Meinig & Partner GbR**
**Patent- und Rechtsanwälte**
**Joachimstaler Strasse 10-12**
**10719 Berlin (DE)**

(56) Entgegenhaltungen:
DE-A1- 3 023 155        DE-A1- 4 008 768
GB-A- 763 569           JP-A- 58 119 300

• **MARSELLI S ET AL: "Porous piezoelectric ceramic hydrophone" JOURNAL OF THE ACOUSTICAL SOCIETY OF AMERICA, Bd. 106, Nr. 2, August 1999 (1999-08), Seiten 733-738, XP012001137 ISSN: 0001-4966**

**Beschreibung**

Die Erfindung betrifft einen Schwingungswandler mit einem piezoelektrischen Element zur Umwandlung von Drucksignalen in elektrische Signale und umgekehrt nach dem Oberbegriff des Hauptanspruchs.

Aus der DE 40 29 972 ist ein Piezoelement bekannt, das als Ultraschallwandler ausgebildet ist und das aus mehreren übereinander angeordneten Schichten aus einer porösen Piezokeramik mit dazwischen geschalteten Elektroden besteht. Jede Schicht der porösen Piezokeramik wird durch Ziehen einer Kunststofffolie durch ein Vorratsgefäß, das einen mit einem Perlpolymerisat gemischten Keramikschlicker enthält, hergestellt. Der Folienstapel wird anschließend gepresst und gebrannt. Innerhalb jeder Schicht weist die poröse Piezokeramik bezüglich der Porosität einen Gradienten auf, wobei an den Grenzflächen zur Verbesserung des Kontaktes zu den Elektroden eine minimale Porosität vorhanden ist.

Schwingungswandler werden für die unterschiedlichsten Zwecke eingesetzt, sie können in Mikrofonen, insbesondere Kontaktmikrofonen für Zwecke der Nachrichtenübermittlung, in Beschleunigungsaufnehmern, Geräten der Auskultativ-Diagnostik, der seismischen Bodenuntersuchung oder dergleichen, in Sicherheitssignalsystemen und anderen Anlagen Verwendung finden.

Aus der EP 0 515 521 B1 ist ein piezokeramischer Beschleunigungsaufnehmer bekannt, der ein kastenförmiges zweiteiliges Gehäuse aus Glas oder Keramik aufweist, in dem ein Hohlraum ausgebildet ist, wobei zwischen den zwei Teilen des Gehäuses eine piezokeramische Platte befestigt ist, die in den Hohlraum eingreift. Die piezokeramische Platte ist im Randkantenbereich, der zur Befestigung zwischen den Gehäusehälften dient, mit Elektroden versehen, wobei die Gehäusehälften Metallisierungen zur Verbindung der Elektroden mit Kontaktverbindungsstellen zu einer elektrischen Schaltung aufweisen.

In der GB 763 569 A ist ein keramischer elektromechanischer Wandler vorgesehen, der einen Körper in Zellenstruktur aufweist und der Körper im Wesentlichen aus gebrannten dielektrischem Keramikmaterial besteht. Auf zwei gegenüberliegenden Seitenflächen sind Elektroden angeordnet, die eine Beschichtung aus einem Gummi-Material aufweisen. Die Seitenkanten sind mit einem aushärtbaren Harz beschichtet.

DE 40 08 768 A1 offenbart einen piezoelektrischen Wandler aus poröser PZT-Keramik mit allseitigen Beschichtung aus einem Urethan-Harzfilm. Marselli et al. beschreiben in J. Acoust. Soc. Am. 106(2), 733-738 (1999) einen ähnlichen Wandler aus PZT mit zusammenhörigenden Poren, der in Polyurethanharz eingebettet ist.

Der Erfindung liegt die Aufgabe zugrunde, einen Schwingungswandler mit einem piezoelektrischen Element zur Umwandlung von Drucksignalen in elektrische Signale und umgekehrt zu schaffen, bei dem die Empfindlichkeit angehoben und gleichzeitig eine ausreichende mechanische Stabilität zur Verfügung gestellt wird, wobei hinsichtlich des Schwingungswandlers die erhöhte Empfindlichkeit besonders in eine Richtung ausgebildet ist.

Diese Aufgabe wird erfindungsgemäß durch die Merkmale des Hauptanspruchs gelöst.

Durch die in den Unteransprüchen angegebenen Maßnahmen sind vorteilhafte Weiterbildungen und Verbesserungen möglich.

Unter poröser Piezokeramik ist piezokeramisches Material zu verstehen, z.B. auf der Basis eines über piezoelektrische Eigenschaften verfügendes verfestigtes Bleititanzirkonat-Gemisch, das Poren enthält. In Abhängigkeit davon, ob der Keramikkörper geschlossene, d.h. isolierte oder offene, d.h. kommunizierende Poren einschließt, gehört die poröse Piezokeramik zu den Piezokomposita, die einer Bindung 3-0 oder 3-3 entsprechen.

Es hat sich gezeigt, dass beim Übergang von hochfesten, porenarmen Keramiken zu hochporösen Piezokeramiken die piezoelektrische Spannungskonstante $g_H$ (Luftschallempfindlichkeit/Dicke der Piezokeramik), die ein Maß für die Empfindlichkeit ist, signifikant anwächst, wobei insbesondere bei einer Porosität von mehr als 30 Vol.-% eine nicht lineare Erhöhung der elastischen Verformbarkeit der Keramik und eine der Zunahme der Keramikporosität entsprechende Verringerung der Poissonschen Zahl, d.h. des Querkontraktionskoeffizienten, auftreten. Die erste Eigenschaft gewährleistet ein hohe Empfindlichkeit und die zweite bewirkt, dass bei allseitiger räumlicher Einwirkung einer mechanischen Schwingung die Höhe der piezoelektrischen Spannungskonstanten $g_H$, d.h. der Empfindlichkeit, in der Polarisationsachse voll erhalten bleibt, während er sich bei festen Keramiken aufgrund der Überlagerung der Signalkomponenten der Hauptachse, d.h. Polarisationsachse, mit den gegenphasigen Signalkomponenten der Nebenachsen verringert, also unempfindlicher wird.

Am prägnantesten zeigt sich diese Wirkung bei der porösen Keramik mit offenen Poren, wobei sich jedoch mit der Zunahme der Porosität des Keramikkörpers dessen mechanische Festigkeit verringert, so dass höchstporöse Keramik üblicherweise nicht verwendet wird. Es ist bekannt, für eine Verbesserung der mechanischen Stabilität der hochporösen Piezokeramik mit offenen Poren zur Füllung der Poren verschiedene Polymerkomposita zu verwenden, obwohl sich dabei die volumetrische Piezoempfindlichkeit wesentlich verringert. Typische Füllstoffe sind dabei Epoxydharz und Silikonkautschuk.

Dadurch, dass gemäß der Erfindung der poröse Keramikkörper offene Poren aufweist und zumindest auf der nicht von den Elektroden eingenommenen Oberfläche mit einer elastischen Beschichtung versehen ist, wird die piezoelektrische Spannungskonstante des piezoelektrischen Elementes wesentlich erhöht, wobei die elastische Beschichtung die mechanische Festigkeit des Keramikkörpers verbessert. Dabei ist besonders vorteilhaft, wenn der Keramikkörper auf seiner gesamten Oberfläche mit der Beschichtung hermetisch abgedeckt ist.

Die Rolle der elastischen Beschichtung besteht außer in der Erhöhung der mechanischen Festigkeit des Keramikkörpers mit höherer Porosität, wodurch dessen Verwendung in einem piezoelektrischen Element zur Umwandlung von Drucksignalen in elektrische Signale und umgekehrt möglich ist, darin, dass dank dieser Beschichtung bei Einwirkung von beispielsweise einer akustischen Welle ein Druckgefälle zwischen dem Innenvolumen des Piezoelementes und dem umgebenden Medium entsteht und eine entsprechende erhöhte Verformung des Piezoelementes bewirkt. Aufgrund der niedrigen Poissonschen Zahl der hochporösen Piezokeramik wird die erhöhte volumetrische Verformung in eine einachsige, vorrangig longitudinale Verformung transformiert, die infolge des direkten Piezoeffektes das Auftreten einer elektrischen Ladung an den Elektroden des Piezoelementes auslöst. Im Endergebnis wird das volumetrische Ausgangssignal durch das Piezoelement aus poröser Keramik mit der elastischen Beschichtung in ein ausreichend hohes elektrisches Signal transformiert. Bei Fehlen der elastischen Beschichtung ist die Verformung des Piezoelementes wesentlich geringer, weil kein Druckgradient entsteht und damit seine piezoelektrische Spannungskonstante ebenfalls niedriger ist.

In vorteilhafter Weise ist der poröse Keramikkörper hinsichtlich der Verteilung der offenen miteinander kommunizierenden Poren, über den gesamten Querschnitt im Wesentlichen homogen. Damit durch fremde Materialien nicht das "Atmen", durch das der Druckgradient innerhalb des Keramikkörpers erhöht wird, gestört wird, sind die Poren lediglich mit Luft oder Gas und nicht mit festen Füllstoffen gefüllt und es wird eine Sandwichbauweise mit unterschiedlichen Materialien vermieden.

Auch die Dicke der elastischen Beschichtung, die eine Elastizität im Bereich von 10 bis 50 Shore A, vorzugsweise zwischen 10 und 30 A Shore liegen kann, ist in Abhängigkeit des Materials so zu wählen, dass die Verformung nicht behindert wird. Diese Dicke liegt im Bereich von 0,1 bis 1,5 mm, vorzugsweise beträgt sie etwa 0,1 bis 0,5 mm.

Die Porosität ist vorteilhafterweise so hoch wie möglich zu wählen, die obere Grenze ist durch die benötigte Festigkeit, die gewünschte Empfindlichkeit und das Herstellungsverfahren begrenzt.

Dadurch, dass der erfindungsgemäße Schwingungswandler ein piezoelektrisches Element mit dem porösen Keramikkörper mit offenen Poren umfasst, das mit einer Stirnseite an dem Boden eines Gehäuses im Wesentlichen starr befestigt wird, die entgegengesetzte Stirnfläche des Piezoelementes die empfindliche Fläche darstellt und das Volumen des Gehäuses zumindest teilweise mit einer Vergussmasse gefüllt ist, wobei das piezoelektrische Element von der Vergussmasse mechanisch entkoppelt ist, wird eine hohe Empfindlichkeit des Schwingungswandlers für Schwingungssignale mit einem guten Signal/Rauschabstand erzielt und durch die mechanische Entkopplung wird sein Amplitudenfrequenzgang verbessert, wobei aufgrund der starren Verbindung des porösen Keramikkörpers mit dem Gehäuseboden und aufgrund der umgebenden Vergussmasse die Empfindlichkeit gerichtet ist.

Weiterhin vorteilhaft ist, dass das Gehäuse auf einem Rahmen aus schwingungsabsorbierendem Material aufgesetzt und mit diesem verbunden ist, d.h. elastisch und schwingungsdämpfend gelagert ist, da somit die Empfindlichkeit des Wandlers gegen Fremdschwingungen unter Beibehaltung der hohen Empfindlichkeit bezüglich der von der Vorderseite auftreffenden Schwingungssignale stark verringert wird, wobei diese Wirkung noch weiter verbessert wird, wenn der Rahmen aus einer das Gehäuse umgebenden Hülse und einer Bodenplatte besteht, wobei zwischen Hülse und Gehäuse und Bodenplatte und Gehäuse ein Zwischenraum, ausgefüllt mit einem schwingungsdämpfenden oder schwingungsabsorbierenden Medium vorgesehen ist.

Ausführungsbeispiele der Erfindung sowie ein piezoelektrisches Element dafür sind in den Zeichnungen dargestellt und werden in der nachfolgenden Beschreibung näher erläutert. Es zeigen:

Fig. 1     einen Schnitt durch das piezoelektrische Element geeignet für ein Ausführungsbeispiel der vorliegenden Erfindung.

Fig. 2     einen Schnitt durch einen Schwingungswandler nach einem ersten Ausführungsbeispiel, und

Fig. 3     einen Schnitt durch ein weiteres Ausführungsbeispiel des erfindungsgemäßen Schwingungswandlers.

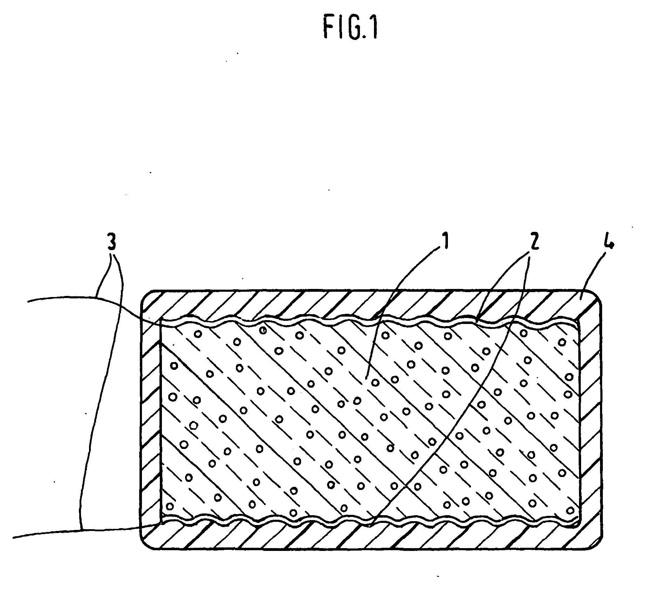

In der Figur 1 ist mit 1 ein poröser im Wesentlichen homogener Keramikkörper bezeichnet, der offene Poren aufweist, wobei das von den Poren eingenommene Volumen nicht kleiner als 10% beträgt, vorzugsweise größer als 30%, beispielsweise liegt die Porosität zwischen 50 und 70%. Die Poren sind üblicherweise mit Luft gefüllt, können jedoch auch ein anderes Gas enthalten. An zwei gegenüberliegenden Oberflächen des Keramikkörpers 1 sind Elektroden 2 aufgebracht, die mit Anschlussdrähten 3 verbunden sind. Der Kerämikkörper 1 ist über seinen gesamten Umfang, gegebenenfalls abgesehen von der von den Elektroden 2 eingenommenen Oberfläche, mit einer hermetisch dichten elastischen Beschichtung 4 versehen, beispielsweise aus einem Polymer wie Polyurethan, Silikonkautschuk, Isoprenkautschuk und dergleichen. Die elastische Beschichtung darf nur so dick sein, dass die Verformbarkeit des Keramikkörpers aufgrund der Schwingungen erhalten bleibt, d.h. die Verformung nicht behindert wird, wobei dies gleichermaßen für die Elastizität der Beschichtung gilt. Die Elastizität sollte beispielsweise in einem Bereich von 10 bis 50 Shore A, vorzugsweise in einem Bereich von 10 bis 30 Shore A liegen. Die Schichtdicke der elastischen Beschichtung kann in Abhängigkeit vom verwendeten Material in einem Bereich zwischen 0,1 bis 1,5 mm, vorzugsweise zwischen 0,1 bis 1,0 mm liegen. Besonders gute Ergebnisse wurden zwischen 0,1 und 0,5 mm erreicht.

Beispiele:

Als konkrete beispielhafte Ausführungen wurden Piezoelemente aus piezokeramischem Material PTZ-36 mit einer Porosität von 62-63 Vol.-% in Form von Scheiben mit einem Durchmesser von 12 mm und einer Höhe von 5 mm gefertigt. Die Oberflächen der Elemente wurden von außen, nach Aufbringung einer Metallschicht auf die Stirnseiten der Scheiben, Anlöten von Drähten zur Signalabnahme an diesen Schichten und Polarisierung der Keramikkörper zwecks Vergleichs mit einer Schicht unterschiedlicher elastischer Polymere wie Polyurethan, Silikonkautschuk und synthetischem Kautschuk und unelastischer Polymere wie Epoxydharz, Polymethylmethakrylat abgedichtet.

Die piezoelektrische Spannungskonstante $g_H$ wurden entsprechend der Formel

$$g_H = \gamma / h$$

bestimmt, wobei $\gamma$ die Luftschallempfindlichkeit des Keramikkörpers in mV/Pa und h die Höhe des Keramikkörpers darstellen, gemessen in einem reflexionsarmen Raum bei einer Frequenz von 1000 Hz. Die erzielten Ergebnisse sind in der Tabelle 1 aufgeführt.

Tabelle 1

| Pos.-Nr. | Beschichtungsmaterial mit dem Parameter Schichtdicke h=0,5 mm | $g_H$[mV·m/N] |
|---|---|---|
| 1 | Epoxydharz | 28 |
| 2 | Polymethylmethakrylat | 28 |
| 3 | Polyurethan | 252 |
| 4 | Silikonkautschuk | 280 |
| 5 | Synthetischer Isoprenkautschuk | 294 |
| 6 | Ohne Beschichtung | 14 |

Aus den angeführten Daten folgt, dass durch Verwendung von elastischen Beschichtungen eine hohe piezoelektrische Spannungskonstante der Elemente aus offen poröser Keramik erhalten wird, wobei die Empfindlichkeit desselben Keramikkörpers ohne Beschichtung um das 20-fache überstiegen wird. Aus der Tabelle 1 folgt ebenfalls, dass eine unelastische Beschichtung zu einem Ansteigen der piezoelektrischen Spannungskonstanten um lediglich das 2-fache führt.

Der positive Einfluss einer elastischen Beschichtung auf die Piezoempfindlichkeit tritt in einem breiten Frequenzband auf, wobei in der Tabelle 2 die piezoelektrische Spannungskonstante $g_H$(mV·m/N) in Abhängigkeit von der Frequenz für eine elastische und eine unelastische Beschichtung aufgeführt sind.

Tabelle 2

| Frequenz (in Hz) | 10 | 100 | 1000 | 5000 | 10000 | 15000 |
|---|---|---|---|---|---|---|
| $g_H$ mit elastischer Beschichtung | 230 | 250 | 280 | 230 | 250 | 265 |
| $g_H$ mit unelastischer Beschichtung | 10 | 14 | 28 | 28 | 28 | 28 |

Im Unterschied zur Beschaffenheit der Porosität (offene oder geschlossene Poren) beeinflusst die Größe der Poren die Piezoempfindlichkeit nur gering. Tabelle 3 zeigt die Empfindlichkeitswerte von Piezoelementen mit derselben offenen Porosität in Abhängigkeit von der Porengröße bei einer Beschichtung mit Silikonkautschuk.

Tabelle 3

| Porengröße (in $\mu$m) | $g_H$[mV·m/N] |
|---|---|
| 20-80 | 280 |
| 50-200 | 308 |
| 100-500 | 300 |
| 500-1000 | 280 |

In einem weiteren Beispiel gemäß Tabelle 4 ist die Piezoempfindlichkeit in Abhängigkeit von der Schichtdicke des Beschichtungsmaterials ohne zusätzliche Massebeaufschlagung bei einer Porosität von 56% dargestellt.

| Schichtdicke [mm] | 0, 0 | 0,1 | 0,5 | 1,0 | 1,5 | 2,0 | 2,5 |
|---|---|---|---|---|---|---|---|
| Luftschallempfindlichkeit [mV/Pa] | 0,02 | 0,7 | 0,7 | 0,7 | 0,45 | 0,33 | 0,21 |
| Körperschallempfindlichkeit [mV/g] | 1,2 | 25 | 27 | 20 | 15 | 11 | 7 |

Es ist zu erkennen, dass mit einer Schichtdicke von 0,1 und 0,5 mm die größten Empfindlichkeiten erzielt werden.

Mit dem piezoelektrischen Element wird eine sehr viel höhere Piezoempfindlichkeit erzielt, und es weist eine einfachere Konstruktion auf. Im Vergleich zu Piezoelementen aus fester Piezokeramik weist das Piezoelement eine um nahezu zwei Größenordnungen höhere piezoelektrische Spannungskonstante auf und ist durch ein breites Frequenzspektrum (10 Hz bis 200 kHz) und einen gleichmäßigen Amplitudenfrequenzgang, bei dem die Schwankungen im Audiofrequenzband 6 dB nicht übersteigen, gekennzeichnet.

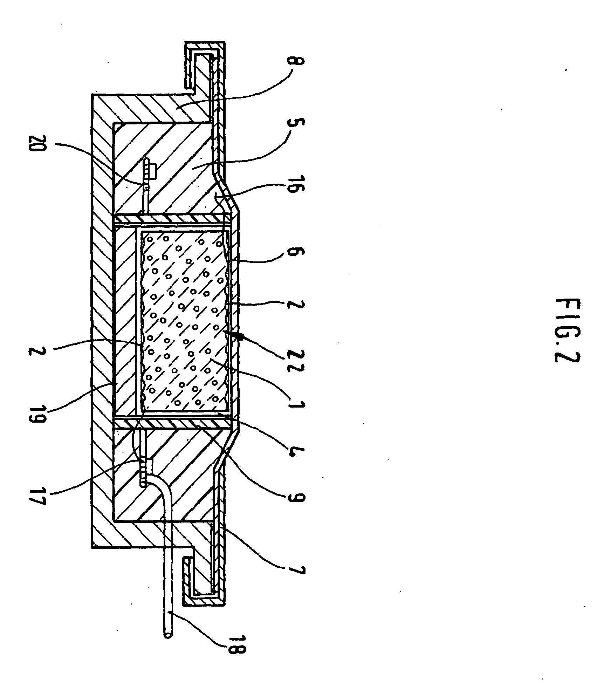

In Fig. 2 ist ein Schwingungswandler nach einem ersten Ausführungsbeispiel der Erfindung dargestellt, der das oben beschriebene Piezoelement verwendet. Der Schwingungswandler weist ein in einem Gehäuse 8 aufgenommenes piezoelektrisches Element 22 auf, wobei das piezoelektrische Element 22 von einer das Gehäuse 8 ausfüllenden Vergussmasse 5 umgeben wird. Das Gehäuse 8 ist z.B. topfförmig ausgebildet und ist nach einer Seite, in der Fig. 2 nach oben offen, wobei das piezoelektrische Element 22 etwas über das Niveau der Vergussmasse 5 hinausragt und die empfindliche Sensorfläche des Piezoelementes 22 darstellt. Das Gehäuse 8, d.h. das Piezoelement 22 und die Vergussmasse 5 sind mit einer Abschirmfolie 6, bestehend aus Metallfolie oder feinem Drahtgewebe oder metallisierter Kunststofffolie oder elektrisch leitendem Polymer abgedeckt. Das Gehäuse weist einen flanschartigen Rand auf, der von einem gebördelten Ring 7 umgeben ist, wobei der Ring 7 die Abschirmfolie 6 und den Rand des Gehäuses 8 übergreift.

Das Piezoelement 22 ist mit den Elektroden 2 zur elektrischen Signalweiterleitung versehen. Die Elektroden 2 sind mit einer Impedanzwandlerschaltung 20 verbunden, durch die die entsprechende elektrische Anpassung realisiert wird. Die obere Elektrode 2 ist über eine Verbindung 16 mit der Abschirmfolie 6 verbunden, während die untere Elektrode 2 über die Leitung 17 mit der Impedanzwandlerschaltung 20 verbunden ist. Ein Anschlusskabel 18 führt nach außen.

Der poröse Keramikkörper 1 ist zur mechanischen Stabilisierung und zur Erhöhung des Druckgradienten mit der elastischen Beschichtung 4 versehen, die den Keramikkörper 1 auf seiner gesamten Oberfläche hermetisch umgibt.

Bei der Herstellung des Schwingungswandlers nach Fig. 2 wird der mit der elastischen Polymerbeschichtung 4 versehene poröse Keramikkörper 1 mit einer Stirnseite über eine starre Verbindung 19, z.B. einer Klebeschicht am Gehäuseboden befestigt. Der mit der elastischen Beschichtung 4 versehene Keramikkörper 1 wird von einer locker d.h. nicht fest mit ihm verbundenen Hülle 9 umgeben, die beispielsweise als Siliconschlauch ausgebildet ist, der über den Keramikkörper 1 gestülpt wird, und anschließend wird das Gehäuse mit einer Vergussmasse, mit einem Epoxidharz oder einem anderen schwach elastischen Kompound ganz oder teilweise aufgefüllt. Dabei trennt die Hülle 9 das Piezoelement 22 von der Vergussmasse 5 und bildet die mechanische Entkopplung. Die mit den Elektroden verbundene Impedanzwandlerschaltung wird mit eingegossen und wird von der Vergussmasse 5 umgeben.

Als Ergebnis einer solchen Anordnung nach Fig. 2 wird erreicht, dass die Rückseite des Keramikkörpers mit der trägen Masse des Gehäuses 8 maximal "belastet" und seine Vorderseite maximal "entlastet" wird, was die Empfindlichkeit des Schwingungswandlers auf seiner Vorderseite erhöht und gleichzeitig seine Empfindlichkeit auf der Rückseite herabsetzt. Die Verwendung der Schutzhülle 9 für die Mantelfläche bzw. Seitenfläche des Piezoelementes 22 gestattet es außerdem, ohne Einbußen an Wandlerempfindlichkeit für das Vergießen des Gehäuses ein schwach elastisches Kompound einzusetzen, was es möglich macht, die Eigenresonanz des Wandlers in die höherfrequenten Bereiche zu verschieben und damit seinen Amplitudenfrequenzgang im Niederfrequenzbereich zu verbessern.

Ein solcher Wandler kann, wie schon ausgeführt, als Kontakt- oder Körperschallmikrofon verwendet werden, wobei dann nur die über die Frontseite des Gehäuses 8 herausragende Stirnfläche des Piezoelementes 22 mit der Oberfläche einer Signalquelle Kontakt hat.

Ein Beispiel eines in Fig. 2 dargestellten Wandlers weist eine Höhe von 5,8 mm, einen Durchmesser von 21,5/18,0 mm und ein Gewicht von etwa 7 g auf, wobei der Körperschall-Übertragungskoeffizient 1500 mV/g beträgt, der Amplitudenfrequenzgang im Frequenzbereich von 50 - 5000 Hz innerhalb eines 6 dB Toleranzschlauches verläuft und das Verhältnis der Empfindlichkeit seiner Vorder- zur Rückseite einen Wert von etwa 20 dB aufweist.

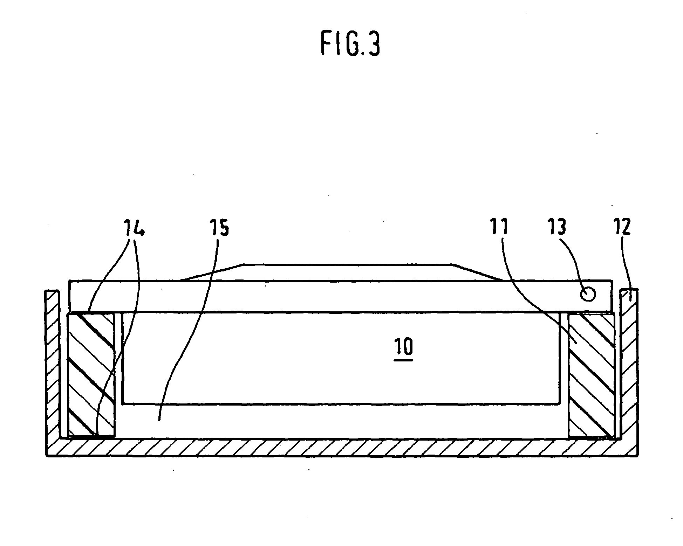

Ein weiteres Ausführungsbeispiel ist in Fig. 3 dargestellt, wobei der Wandler mit 10 bezeichnet ist und den Aufbau entsprechend Fig. 2 aufweisen kann.

Wie zu erkennen ist, wird das Gehäuse 8 über seinen Rand 13 von einer zylinderförmigen Hülse 11 aus elastischem schallabsorbierenden Material abgestützt, die das Gehäuse 8 umfangsmäßig umgibt. Weiterhin ist eine wiederum topfförmige Abdeckkappe 12 vorgesehen, in die das Gehäuse 8 mit Zylinder 11 eingesetzt ist, wobei der Zylinder 11 aus schalldämmendem Material über Verbindungsstellen 14 einerseits mit dem flanschartigen Rand 13 und andererseits mit dem Boden der Abdeckkappe 12 verbunden ist. Dabei ist zwischen dem Boden des Gehäuses 1 und dem Boden der Patrone 12 ein Zwischenraum 15 vorgesehen, der mit einem schwingungsabsorbierenden Medium ausgefüllt ist. Dies kann Luft, Vakuum, Flüssigkeit oder anderes sein.

Im vorliegenden Ausführungsbeispiel wird eine Abdeckkappe verwendet, es können auch andere Konstruktionen vorgesehen werden, um den Schwingungswandler 10 gegen Fremdschwingungen unempfindlich zu machen, wobei jedoch der Grundgedanke der elastischen schallabsorbierenden Aufhängung des Wandlers und des Zwischenraums in der Art eines doppelten Bodens bestehen bleibt.

Aufgrund der Anordnung wird eine starke Verminderung oder sogar eine für bestimmte Frequenzen praktisch vollständige Unterdrückung der Empfindlichkeit des Wandlers gegen Fremdschwingung unter Beibehaltung der hohen Empfindlichkeit für auf ihn von der Vorderseite auftreffende Schwingungssignale bei minimaler Vergrößerung der Wandlerdicke erzielt. Die das Gehäuse des Wandlers umgebende Hülse aus elastischem schalldämpfenden Material, die als Zylinder ausgebildet sein kann, ist mit einer Seite an der Vorderseite des Gehäuses und mit der anderen Seite am Boden der auf den Wandler aufgesteckten Abdeckkappe, oder auch nur an einer Außenscheibe befestigt. Dabei wird zwischen dem Gehäuse des Wandlers und der Scheibe oder zwischen Gehäuse und Boden der Abdeckkappe ein Zwischenraum in der Art eines doppelten Bodens gebildet, der entweder mit einem Gas, einem Vakuum, einer Flüssigkeit oder einem anderen schwingungsabsorbierenden Medium aufgefüllt werden kann.

**Patentansprüche**

1. Schwingungswandler mit einem piezoelektrischen Element zur Umwandlung von Drucksignalen in elektrische Signale und umgekehrt mit einem porösen Keramikkörper und mit mindestens zwei auf den Keramikkörper aufgebrachten Elektroden, wobei der poröse Keramikkörper (1) offene Poren ohne feste Füllstoffe aufweist und zumindest auf der nicht von den Elektroden (2) eingenommenen Oberfläche mit einer elastischen Beschichtung (4) versehen ist, **dadurch gekennzeichnet, dass** das piezoelektrische Element in einem Gehäuse (8) aufgenommen ist, wobei eine Stirnfläche des piezoelektrischen Elementes fest mit dem Gehäuseboden verbunden ist, und die gegenüberliegende Stirnfläche eine für die Schwingungen aus dem Außenraum empfindliche Fläche darstellt, und das piezoelektrische Element (22) in dem Gehäuse (8) von einer Vergussasse (5) umgeben und von dieser mechanisch entkoppelt ist.

2. Schwingungswandler nach Anspruch 1, **dadurch gekennzeichnet, dass** die elastische Beschichtung (4) hermetisch abdichtend ausgebildet ist und die gesamte Oberfläche des Keramikkörpers (1) abdeckt.

3. Schwingungswandler nach Anspruch 1 oder Anspruch 2, **dadurch gekennzeichnet, dass** der poröse Keramikkörper aus einem Bleititanatzirkonat-Gemisch hergestellt ist.

4. Schwingungswandler nach einem der Ansprüche 1 bis 3, **dadurch gekennzeichnet, dass** die Porosität mindestens 10%, vorzugsweise mehr als 30% beträgt.

5. Schwingungswandler nach Anspruch 4, **dadurch gekennzeichnet, dass** die Porosität vorzugsweise zwischen 50 und 70% liegt.

6. Schwingungswandler nach einem der Ansprüche 1 bis 5, **dadurch gekennzeichnet, dass** die Beschichtung (4) aus Silikonkautschuk, Isoprenkautschuk oder Polyurethan oder dergleichen besteht.

7. Schwingungswandler nach einem der Ansprüche 1 bis 6, **dadurch gekennzeichnet, dass** die Dicke der Beschichtung im Bereich von 0,1 bis 1,5 mm, vorzugsweise zwischen 0,1 bis 1,0 mm, noch bevorzugter zwischen 0,1 und 0,5 mm liegt.

**8.** Schwingungswandler nach einem der Ansprüche 1 bis 7, **dadurch gekennzeichnet, dass** die Elastizität der Beschichtung im Bereich von 10 bis 50 Shore A, vorzugsweise zwischen 10 und 30 Shore A liegt.

**9.** Schwingungswandler nach einem der Ansprüche 1 bis 8, **dadurch gekennzeichnet, dass** der poröse Keramikkörper mit offenen Poren im Wesentlichen homogen ist.

**10.** Schwingungswandler nach einem der Ansprüche 1 bis 9, **dadurch gekennzeichnet, dass** die seitliche Umfangsfläche des piezoelektrischen Elementes (22) eine locker mit ihm verbundene Hülle (9) als mechanischen Entkopplung aufweist, die die Vergussmasse (5) vom Piezoelement (22) trennt.

**11.** Schwingungswandler nach einem der Ansprüche 1 bis 10, **dadurch gekennzeichnet, dass** die Elektroden (2) des piezoelektrischen Elementes (22) mit einer Impedanzwandlerschaltung verbunden sind, die in die Vergussmasse (5) eingegossen ist.

**12.** Schwingungswandler nach einem der Ansprüche 1 bis 11, **dadurch gekennzeichnet, dass** die empfindliche Stirnfläche des piezoelektrischen Elementes (22) über das Gehäuse (8) hinausragt.

**13.** Schwingungswandler nach einem der Ansprüche 1 bis 12, **dadurch gekennzeichnet, dass** die empfindliche Stirnfläche von einer Metallfolie oder einem Drahtgewebe oder einer metallisierten Kunststofffolie oder einem elektrisch leitenden Elastomer überzogen ist.

**14.** Schwingungswandler nach einen der Ansprüche 1 bis 13, **dadurch gekennzeichnet, dass** das Gehäuse (8) auf einen Rahmen (11, 12) aus schwingungsabsorbierendem Material aufgesetzt und mit diesem verbunden ist.

**15.** Schwingungswandler nach Anspruch 14, **dadurch gekennzeichnet, dass** der Rahmen eine das Gehäuse (8) zumindest teilweise umgebende Hülse (11) und eine Bodenplatte aufweist, wobei zwischen Hülse (11) und Gehäuse (8) und Bodenplatte und Gehäuse (8) ein Zwischenraum (15) vorgesehen ist, der mit einem schwingungsdämpfenden Medium gefüllt ist.

**16.** Schwingungswandler nach Anspruch 15, **dadurch gekennzeichnet, dass** die Hülse (11) an einem Flansch (13) des Gehäuses (8) befestigt ist und die Bodenplatten Bestandteil einer das Gehäuse (8) umgebenden Abdeckkappe (12) ist.

**Claims**

**1.** A vibration transducer with a piezoelectric element for the conversion of pressure signals into electrical signals and vice versa, with a porous ceramic body and with at least two electrodes applied to the ceramic body, wherein the porous ceramic body (1) has open pores without solid fillers and is provided with a resilient coating (4) at least on the surface not occupied by the electrodes (2), **characterised in that** the piezoelectric element is accommodated in a housing (8), wherein one end face of the piezoelectric element is fixedly connected to the housing base, and the opposite end face constitutes a surface which is sensitive to the vibrations from the exterior, and the piezoelectric element (22) is surrounded in the housing (8) by a casting compound (5) and is mechanically decoupled therefrom.

**2.** A vibration transducer according to claim 1, **characterised in that** the resilient coating (4) is formed so as to provide a hermetic seal and covers the entire surface of the ceramic body (1).

**3.** A vibration transducer according to claim 1 or claim 2, **characterised in that** the porous ceramic body is manufactured from a lead titanate zirconate mixture.

**4.** A vibration transducer according to any one of claims 1 to 3, **characterised in that** the porosity is at least 10%, preferably more than 30%.

**5.** A vibration transducer according to claim 4, **characterised in that** the porosity preferably lies between 50% and 70%.

**6.** A vibration transducer according to any one of claims 1 to 5, **characterised in that** the coating (4) consists of silicone rubber, isoprene rubber or polyurethane or the like.

7. A vibration transducer according to any one of claims 1 to 6, **characterised in that** the thickness of the coating lies in the range from 0.1 to 1.5 mm, preferably between 0.1 and 1.0 mm, more preferably between 0.1 and 0.5 mm.

8. A vibration transducer according to any one of claims 1 to 7, **characterised in that** the resilience of the coating lies in the range from 10 to 50 Shore A, preferably between 10 and 30 Shore A.

9. A vibration transducer according to any one of claims 1 to 8, **characterised in that** the porous ceramic body with open pores is substantially homogeneous.

10. A vibration transducer according to any one of claims 1 to 9, **characterised in that** the lateral circumferential surface of the piezoelectric element (22) has a sheath (9) which is loosely connected thereto and provides mechanical decoupling, which separates the casting compound (5) from the piezoelement (22).

11. A vibration transducer according to any one of claims 1 to 10, **characterised in that** the electrodes (2) of the piezoelectric element (22) are connected to an impedance converter circuit which is cast into the casting compound (5).

12. A vibration transducer according to any one of claims 1 to 11, **characterised in that** the sensitive end face of the piezoelectric element (22) projects beyond the housing (8).

13. A vibration transducer according to any one of claims 1 to 12, **characterised in that** the sensitive end face is covered by a metal foil or a wire cloth or a metallised plastics film or an electrically conductive elastomer.

14. A vibration transducer according to any one of claims 1 to 13, **characterised in that** the housing (8) is placed onto a frame (11, 12) of vibration-absorbing material and is connected thereto.

15. A vibration transducer according to claim 14, **characterised in that** the frame has a sleeve (11), which at least partly surrounds the housing (8), and a base plate, wherein a gap (15), which is filled with a vibration-damping medium, is provided between the sleeve (11) and the housing (8) and the base plate and the housing (8).

16. A vibration transducer according to claim 15, **characterised in that** the sleeve (11) is fastened to a flange (13) of the housing (8), and the base plate is part of a covering cap (12) surrounding the housing (8).


**Revendications**

1. Convertisseur de vibrations, comportant un élément piézoélectrique pour convertir des signaux de pression en signaux électriques et vice versa, comportant un corps céramique poreux et au moins deux électrodes appliquées au corps céramique, dans lequel le corps céramique poreux (1) présente des pores ouverts sans charges solides et est muni au moins sur la surface non occupée par les électrodes (2) d'un revêtement élastique (4), **caractérisé en ce que** l'élément piézoélectrique est reçu dans un boîtier (8), une face frontale de l'élément piézoélectrique étant reliée solidement au fond de boîtier, et la face frontale opposée représente une surface sensible aux vibrations provenant de l'extérieur, et l'élément piézoélectrique (22) dans le boîtier (8) est entouré d'une masse de scellement (5) et est mécaniquement découplé de celle-ci.

2. Convertisseur de vibrations selon la revendication 1, **caractérisé en ce que** le revêtement élastique (4) est réalisé de façon étanche et recouvre toute la surface du corps céramique (1).

3. Convertisseur de vibrations selon la revendication 1 ou 2, **caractérisé en ce que** le corps céramique poreux est fabriqué à partir d'un mélange de plomb, titanate et zirconate.

4. Convertisseur de vibrations selon l'une quelconque des revendications 1 à 3, **caractérisé en ce que** la porosité est au moins de 10 %, de préférence de plus de 30 %.

5. Convertisseur de vibrations selon la revendication 4, **caractérisé en ce que** la porosité se situe de préférence entre 50 et 70 %.

6. Convertisseur de vibrations selon l'une quelconque des revendications 1 à 5, **caractérisé en ce que** le revêtement (4) se compose de caoutchouc silicone, de caoutchouc polyisoprène ou de polyuréthane ou similaires.

7. Convertisseur de vibrations selon l'une quelconque des revendications 1 à 6, **caractérisé en ce que** l'épaisseur du revêtement se situe dans la plage de 0,1 à 1,5 mm, de préférence entre 0,1 à 1,0 mm, de plus grande préférence entre 0,1 et 0,5 mm.

8. Convertisseur de vibrations selon l'une quelconque des revendications 1 à 7, **caractérisé en ce que** l'élasticité du revêtement se trouve dans la plage de 10 à 50 Shore A, de préférence entre 10 et 30 Shore A.

9. Convertisseur de vibrations selon l'une quelconque des revendications 1 à 8, **caractérisé en ce que** le corps céramique poreux avec des pores ouvertes est substantiellement homogène.

10. Convertisseur de vibrations selon l'une quelconque des revendications 1 à 9, **caractérisé en ce que** la surface périphérique latérale de l'élément piézoélectrique (22) présente une douille (9) librement reliée à celui-ci en tant que découplage mécanique qui sépare la masse de scellement (5) de l'élément piézoélectrique (22).

11. Convertisseur de vibrations selon l'une quelconque des revendications 1 à 10, **caractérisé en ce que** les électrodes (2) de l'élément piézoélectrique (22) sont reliées à un circuit de transformation d'impédance qui est scellé dans la masse de scellement (5).

12. Convertisseur de vibrations selon l'une quelconque des revendications 1 à 11, **caractérisé en ce que** la surface frontale sensible de l'élément piézoélectrique (22) dépasse du boîtier (8).

13. Convertisseur de vibrations selon l'une quelconque des revendications 1 à 12, **caractérisé en ce que** la surface frontale sensible est recouverte d'un film métallique ou d'un treillis métallique ou d'un film plastique métallisé ou d'un élastomère électroconducteur.

14. Convertisseur de vibrations selon l'une quelconque des revendications 1 à 13, **caractérisé en ce que** le boîtier (8) est posé sur un cadre (11, 12) en matériau absorbant des vibrations et est relié à celui-ci.

15. Convertisseur de vibrations selon la revendication 14, **caractérisé en ce que** le cadre présente une douille (11) entourant au moins en partie le boîtier (8) et une plaque de fond, dans lequel entre la douille (11) et le boîtier (8) et la plaque de fond et le boîtier (8) un espace (15) est prévu qui est comblé par un milieu amortisseur de vibrations.

16. Convertisseur de vibrations selon la revendication 15, **caractérisé en ce que** la douille (11) est fixée à une bride (13) du boîtier (8) et les plaques de fond font partie d'un capot (12) entourant le boîtier (8).

FIG.1

# FIG.2

# FIG.3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 4029972
- EP 0515521 B1
- GB 763569 A
- DE 4008768 A1

### In der Beschreibung aufgeführte Nicht-Patentliteratur

- **MARSELLI et al.** *J. Acoust. Soc. Am.,* 1999, vol. 106 (2), 733-738